# EUROPÄISCHE PATENTSCHRIFT

(11) **EP 2 076 939 B1**
(45) Veröffentlichungstag und Bekanntmachung des Hinweises auf die Patenterteilung: **04.08.2010**
(21) Anmeldenummer: 07820576.2
(22) Anmeldetag: 26.09.2007
(51) Int. Cl.: H01R 11/28

(54) **BATTERIESENSOREINHEIT**
BATTERY SENSOR UNIT
CAPTEUR DE BATTERIE

(30) Priorität: 28.09.2006 DE 102006046137
(43) Veröffentlichungstag der Anmeldung: 08.07.2009
(73) Patentinhaber: Continental Automotive GmbH, 30165 Hannover (DE)
(72) Erfinder: SCHIMMEL, Ralf, 35789 Weilmuenster (DE)
(86) Internationale Anmeldenummer: PCT/EP2007/060181
(87) Internationale Veröffentlichungsnummer: WO 2008/037724

(56) Entgegenhaltungen:
- DE-A1-102004 055 847
- DE-B3-102004 033 127

## Beschreibung

Die Erfindung bezieht sich auf eine Batteriesensoreinheit mit einer an einen Pol einer Kraftfahrzeugbatterie anschließbaren Befestigungseinrichtung, insbesondere einer Polklemme, die mit einem plattenartigen Trägerelement elektrisch leitend verbunden ist, und mit einem sich in einem Abstand parallel zum Trägerelement erstreckenden planaren Messshunt, der aus einem Widerstahdselement und beidseitig sich daran anschließenden Widerstandsanschlüssen besteht, wobei das Trägerelement mit seinem einen freien Endbereich stoffschlüssig und elektrisch leitend mit dem einen Widerstandsanschluss verbunden ist und der zweite freie Endbereich des Trägerelements elektrisch isoliert mit dem zweiten Widerstandsanschluss verbunden ist, wobei zwischen dem zweiten freien Endbereich des Trägerelements und dem zweiten Widerstandsanschluss ein Abstandshalter aus einem elektrisch isolierenden Werkstoff angeordnet ist, an dem der zweite freie Endbereich des Trägerelements und der zweite Widerstandsanschluss mit ihren einander zugewandten Seiten in Anlage sind und der sowohl mit dem zweiten freien Endbereich des Trägerelements als auch mit dem zweiten Widerstandsanschluss verbindbar ist und wobei der Abstandshalter mittels einer lösbaren Verbindung mit dem zweiten freien Endbereich des Trägerelements und/oder mit dem zweiten Widerstandsanschluss verbindbar ist.

Bei einer derartigen Batteriesensoreinheit ist es bekannt, den zweiten freien Endbereich des Trägerelements mittels einer Schraube an dem zweiten Widerstandsanschluss zu befestigen, wobei in allen Kontaktbereichen zwischen der Schraube und dem Trägerelement sowie zwischen dem Trägerelement und dem zweiten Widerstandsanschluss Isolierungen vorhanden sein müssen.

Dieser Aufbau erfordert nicht nur eine Vielzahl an Bauteilen sondern ist auch aufwendig in der Montage.

Aus der DE 10 2004 055 847 A1, die als nächstliegender Stand der Technik angesehen wird, ist eine Batteriesensoreinheit der eingangs genannten Art bekannt. Dabei ist der zweite freie Endbereich des Trägerelements mittelsveiner Schraube mit dem Widerstandsanschluss verbunden. Im Bereich der Verschraubung sind zwischen Widerstandsanschluss und Trägerelement sowie zwischen Schraube und Trägerelement in allen Kontaktzonen Isoliermittel angeordnet.

Aufgabe der Erfindung ist daher eine Batteriesensoreinheit der eingangs genannten Art zu schaffen, die nur wenige einfach aufgebaute Bauteile benötigt, welche leicht und schnell montierbar sind.

Diese Aufgabe wird erfindungsgemäß dadurch gelöst, dass der Abstandshalter mittels einer Rastverbindung mit dem zweiten freien Endbereich des Trägerelements und/oder mit dem zweiten Widerstandsanschluss verbindbar ist.

Durch diese Ausbildung werden Messshunt und Trägerelement exakt zueinander positioniert und können an ihren einen Enden stoffschlüssig miteinander verbunden werden. Der Abstandshalter dient dabei gleichzeitig als Montagehilfe.

Nach der stoffschlüssigen Verbindung werden Messshunt und Trägerelement durch den Abstandshalter in ihrer Sollposition zueinander stabil gehalten, so dass die stoffschlüssige Fügestelle mechanisch entlastet ist und nicht aufbrechen kann.

Messshunt und Trägerelement sind dabei auf einfache Weise an zwei voneinander beabstandeten Stellen mechanisch stabil miteinander verbunden.

Ohne das Erfordernis von Werkzeugen ist der Abstandshalter an Messshunt und Trägerelement einfach montierbar.

Dabei kann der Abstandshalter einen oder mehrere sich quer zur Längserstreckung von Trägerelement und zweiten Widerstandsanschluss erstreckende Federarme aufweisen, die mit ihrem einen Ende am Abstandshalter fest angeordnet sind und an ihrem freien anderen Ende einen Rasthaken aufweisen, durch den ein Randbereich von Trägerelement oder zweiten Widerstandsanschluss umgreifbar ist.

Um eine symmetrische und damit besonders stabile Verbindung herzustellen, kann ein Paar gleichgerichteter Federarme mit einander zugewandten Rasthaken das Trägerelement und/oder den zweiten Widerstandsanschluss zangenartig zwischen sich aufnehmend an seinen Längsseiten umgreifen.

Es ist aber auch möglich, dass ein Paar gleichgerichteter Federarme mit ihren freien Enden eine Ausnehmung im Trägerelement und/oder im zweiten Widerstandsanschluss durchragen und mit einander abgewandten Rasthaken das Trägerelement und/oder den zweiten Widerstandsanschluss am Rand der Ausnehmung umgreifen.

Dabei kann der Abstandshalter etwa H-artig ausgebildet sein, wobei das Trägerelement und der zweite Widerstandsanschluss jeweils an einer Seite des Querbalkens des "H" abgestützt sind und die jeweils nach einer Seite des Querbalkens sich erstreckenden Arme des "H" ein Paar Federarme bilden, wobei die Rasthaken des einen Paares der Federarme den Rasthaken des anderen Paares der Federarme einander entgegengesetzt gerichtet sind.

Dabei umgreifen das eine Paar der Federarme von außen und das andere Paar der Federarme durchragt die Ausnehmung und umgreift deren Ränder von innen.

Vorzugsweise weisen dabei die Federarme des einen Paares der Federarme gegenüber dem anderen Paar der Federarme einen geringeren Abstand zueinander auf.

Ist der Querbalken des "H" als Biegebalken ausgebildet, so können toleranzbedingte Längenunterschiede der Federarme ausgeglichen werden.

Auf eine Vormontage des Abstandshalters kann verzichtet werden, wenn der Abstandshalter einteilig ausgebildet ist.

Besonders kostengünstig ist der Abstandshalter herstellbar, wenn der Abstandshalter ein Kunststoffspritzgussteil ist.

Der erste Widerstandsanschluss kann mit einem Masseanschluss oder mit einem Verbraucher verbindbar sein.

Eine besonders vorteilhafte stoffschlüssige Verbindung von Meßshunt und Trägerelement besteht darin, dass das Trägerelement mit dem ersten Widerstandsanschluss mittels Hartlöten, insbesondere mittels Widerstandshartlöten oder mittels Schweißen, insbesondere mittels Widerstandsschweißen stoffschlüssig verbunden ist, so dass sicher ein gezielter Stromfluss von dem Trägerelement über die stoffschlüssige Verbindung zum Meßshunt erfolgt.

Die Widerstandsanschlüsse können Anschlusselemente zur leitenden Verbindung mit einer Auswerteelektronikeinheit aufweisen.

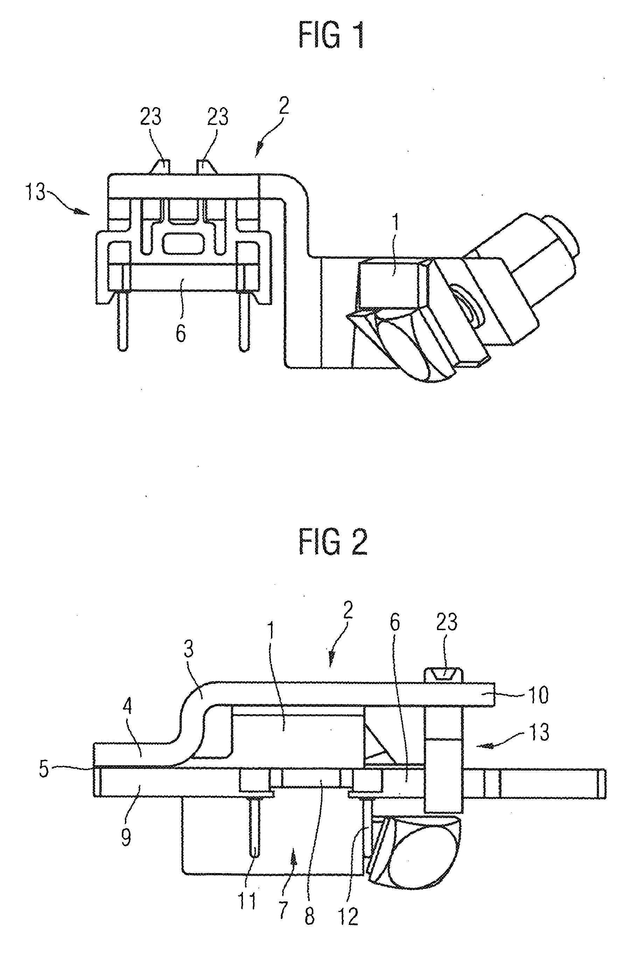

Ausführungsbeispiele der Erfindung sind in der Zeichnung dargestellt und werden im Folgenden näher beschrieben. Es zeigen
- Figur 1: eine Ansicht einer Batteriesensoreinheit;
- Figur 2: eine Seitenansicht der Batteriesensoreinheit nach Figur 1;

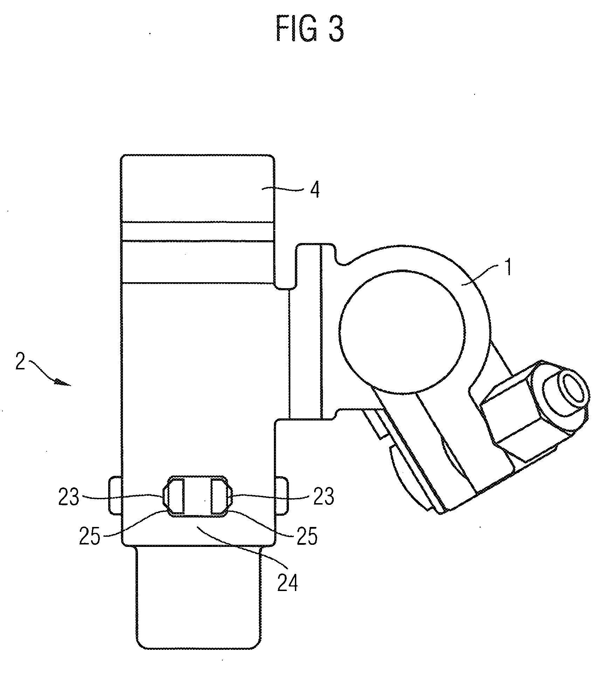

- Figur 3: eine Draufsicht der Batteriesensoreinheit nach Figur 1;
- Figur 4: eine Ansicht eines Abstandshalters der Batteriesensoreinheit nach Figur 1;
- Figur 5: eine Seitenansicht des Abstandshalters nach Figur 4 und
- Figur 6: eine Draufsicht des Abstandshalters nach Figur 4.

Die in der Zeichnung dargestellte Batteriesensoreinheit weist eine aus einem elektrisch leitenden Werkstoff bestehende Polklemme 1 zum Befestigen an einem Minuspol einer Kraftfahrzeugbatterie auf, die einteilig mit einem sich längs erstreckenden plattenartigen Trägerelement 2 ausgebildet ist. Polklemme 1 und Trägerelement 2 können aus Messing oder einer Messinglegierung bestehen.

Das Trägerelement 2 besitzt an seinem einen Endbereich eine Abstufung 3, so dass sich die beidseitig der Abstufung 3 befindlichen Bereiche des Trägerelements 2 in einander parallelen Ebenen erstrecken.

Das kürzere der beiden Bereiche des Trägerelements bildet einen ersten Endbereich 4, der mittels einer Widerstandshartlötung 5 stoffschlüssig mit einem zweiten Widerstandsanschluss 6 eines sich längserstreckenden planaren Meßshunts 7 verbunden ist.

Der Meßshunt 7 besteht aus einem Widerstandselement 8 und an den einander gegenüberliegenden Seiten sich daran anschließend einem ersten Widerstandsanschluss 9 und dem zweiten Widerstandsanschluss 6, die aus Kupfer oder einer Kupferlegierung bestehen können.

Das Widerstandselement 8 und der erste Widerstandsanschluss 9 erstrecken sich in einem bestimmten Abstand parallel zum Trägerelement 2.

Das freie Ende des ersten Widerstandsanschlusses 9 ist über den dem ersten Endbereich 4 entgegengesetzten zweiten Endbereich 10 des Trägerelements 2 hinausragend ausgebildet und kann mit einem Masseanschluss oder mit einem Verbraucher verbunden werden.

An dem ersten Widerstandsanschluss 9 ist ein erstes Anschlusselement 11 und an dem zweiten Widerstandsanschluss 6 ist ein zweites Anschlusselement 12 angeordnet, die leitend mit einer nicht dargestellten elektronischen Auswerteeinheit verbindbar sind.

In dem Bereich, in dem sich der zweite Endbereich 10 des Trägerelements 2 und der zweite Widerstandsanschluss 6 gegenüberliegen, sind der zweite Endbereich 10 und der zweite Widerstandsanschluss 6 mittels eines als Kunststoffspritzgussteil ausgebildeten Abstandshalters 13 sowohl miteinander verbunden als auch den bestimmten Abstand zwischen sich einhaltend abgestützt.

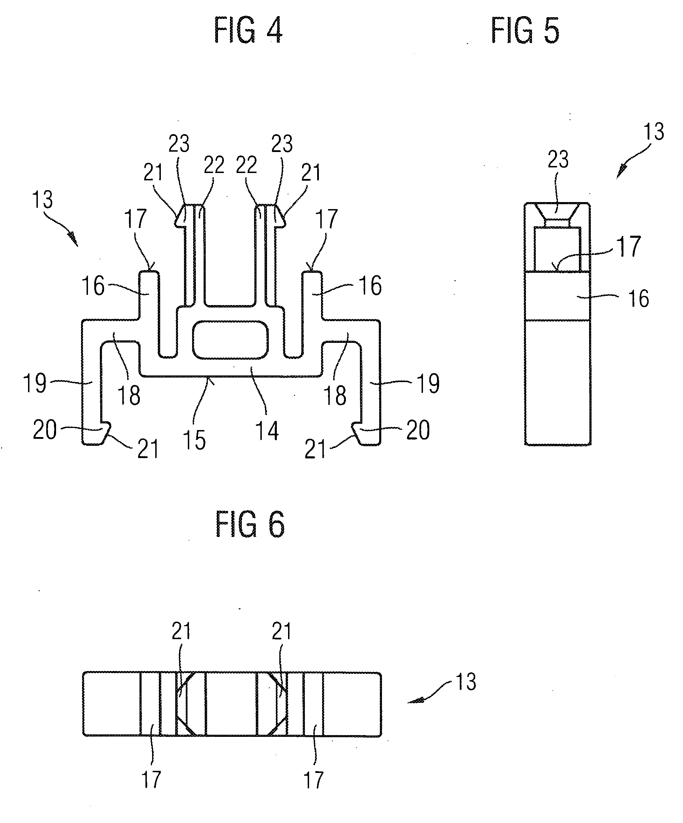

Der in den Figuren 4 bis 6 näher dargestellte Abstandshalter 13 ist etwa "H"-artig ausgebildet.

Der Querbalken 14 des "H" weist an seiner Unterseite eine Anlagefläche 15 auf, mit der er quer auf den zweiten Widerstandsanschluss 6 aufgelegt wird.

Zum leichten Überrasten des zweiten Widerstandsanschlusses 6 besitzen die ersten Rasten 20 rampenartige Abschrägungen 21..

Zwischen den Abstützbalken 16 erstreckt sich gegenläufig zu den ersten Federarmen 19 ein Paar zweite Federarme 22, an deren freien Enden ebenfalls zweite Rasthaken 23 mit Abschrägungen 21 ausgebildet sind, die aber den ersten Rasthaken 20 entgegengerichtet sind.

Im zweiten Endbereich 10 des Trägerelements 2 ist eine durchgehende Ausnehmung 24 rechteckigen Querschnitts ausgebildet.

Die zweiten Federarme 22 durchragen die Ausnehmung 24, wobei die zweiten Rasthaken 23 federnd die einander gegenüberliegenden Ränder 25 der Ausnehmung 24 umgreifen.

## Patentansprüche

1. Batteriesensoreinheit mit einer an einen Pol einer Kraftfahrzeugbatterie anschließbaren Befestigungseinrichtung, insbesondere einer Polklemme, die mit einem plattenartigen Trägerelement elektrisch leitend verbunden ist, und mit einem sich in einem Abstand parallel zum Trägerelement erstreckenden planaren Messshunt, der aus einem Widerstandselement und beidseitig sich daran anschließenden Widerstandsanschlüssen besteht, wobei das Trägerelement mit seinem einen freien Endbereich stoffschlüssig und elektrisch leitend mit dem einen Widerstandsanschluss verbunden ist und der zweite freie Endbereich des Trägerelements elektrisch isoliert mit dem zweiten Widerstandsahschluss verbunden ist, wobei zwischen dem zweiten freien Endbereich des Trägerelements und dem zweiten Widerstandsanschluss ein Abstandshalter aus einem elektrisch isolierenden Werkstoff angeordnet ist, an dem der zweite freie Endbereich des Trägerelements und der zweite Widerstandsanschluss mit ihren einander zugewandten Seiten in Anlage sind und der sowohl mit dem zweiten freien Endbereich des Trägerelements als auch mit dem zweiten Widerstandsanschluss verbindbar ist und wobei der Abstandshalter mittels einer lösbaren Verbindung mit dem zweiten freien Endbereich des Trägerelements und/oder mit dem zweiten Widerstandsanschluss verbindbar ist,
**dadurch gekennzeichnet, dass** der Abstandshalter (13) mittels einer Rastverbindung mit dem zweiten freien Endbereich (10) des Trägerelements (2) und/oder mit dem zweiten Widerstandsanschluss (6) verbindbar ist.

2. Batteriesensoreinheit nach Anspruch 1, **dadurch gekennzeichnet, dass** der Abstandshalter (13) einen oder mehrere sich quer zur Längserstreckung von Trägerelement (2) und zweitem Widerstandsanschluss (6) erstreckend Federarme (19, 22) aufweist, die mit ihrem einen Ende am Abstandshalter (13) fest angeordnet sind und an ihrem freien anderen Ende eine Rasthaken (20, 23) aufweisen, durch die ein Randbereich von Trägerelement (2) oder zweitem Widerstandsanschluss (6) umgreifbar ist.

3. Batteriesensoreinheit nach Anspruch 2, **dadurch gekennzeichnet, dass** ein Paar gleichgerichteter Feiderarme (19) mit einander zugewandten Rasthaken (20) das Trägerelement (2) und/oder den zweiten Widerstandsanschluss zangenartig zwischen sich aufnehmend an seinen Längsseiten umgreift.

4. Batteriesensoreinheit nach einem der vorhergehenden Ansprüche, **dadurch gekennzeichnet, dass** ein Paar gleichgerichteter Federarme (22) mit ihren freien Enden eine Ausnehmung (24) im Trägerelement (2) und/oder im Widerstandsanschluss durchragen und mit einander abgewandten Rasthaken (23) das Trägerelement (2) und/oder den Widerstandsanschluss am Rand (25) der Ausnehmung (24) umgreifen.

5. Batteriesensoreinheit nach den Ansprüchen 3 und 4, **dadurch gekennzeichnet, dass** der Abstandshalter (13) etwa H-artig ausgebildet ist, wobei das Trägerelement (2) und der zweite Widerstandsanschluss (6) jeweils an einer Seite des Querbalkens (14) des "H" abgestützt sind und die jeweils nach einer Seite des Querbalkens (14) sich erstreckenden Arme des "H" ein Paar Federarme (19, 22) bilden, wobei die Rasthaken (20) des einen Paares der Federarme (19) den Rasthaken (23) des anderen Paares der Federarme (22) einander entgegengesetzt gerichtet sind.

6. Batteriesensoreinheit nach Anspruch 5, **dadurch gekennzeichnet, dass** die Federarme (22) des einen Paares der Federarme (22) gegenüber dem anderen Paar der Federarme (19) einen geringeren Abstand zueinander aufweisen.

7. Batteriesensoreinheit nach einem der Ansprüche 5 und 6, **dadurch gekennzeichnet, dass** der Querbalken (14) des "H" als Biegebalken ausgebildet ist.

8. Batteriesensoreinheit nach einem der vorhergehenden Ansprüche, **dadurch gekennzeichnet, dass** der Abstandshalter (13) einteilig ausgebildet ist.

9. Batteriesensoreinheit nach Anspruch 8, **dadurch gekennzeichnet, dass** der Abstandshalter (13) ein Kunststoffspritzgussteil ist.

10. Batteriesensoreinheit nach einem der vorhergehenden Ansprüche, **dadurch gekennzeichnet, dass** der erste Widerstandsanschluss (9) mit einem Masseanschluss oder mit einem Verbraucher verbindbar ist.

11. Batteriesensoreinheit nach einem der vorhergehenden Ansprüche, **dadurch gekennzeichnet, dass** das Trägerelement mit dem ersten Widerstandsanschluss (9) mittels Hartlöten, insbesondere mittels Widerstandshartlöten oder mittels Schweißen, insbesondere mittels Widerstandsschweißen stoffschlüssig verbunden ist.

12. Batteriesensoreinheit nach einem der vorhergehenden Ansprüche, **dadurch gekennzeichnet, dass** die Widerstandsanschlüsse (9, 6) Anschlusselemente (11, 12) zur leitenden Verbindung mit einer Auswerteelektronikeinheit aufweisen.

## Claims

1. Battery sensor unit having a fastening device, in particular a pole terminal, which can be connected to a pole of a motor vehicle battery and is electrically conductively connected to a plate-like carrier element, and having a planar measuring shunt which extends parallel to the carrier element at a distance from the latter and comprises a resistance element and resistance connections which adjoin both sides of the latter, one free end region of the carrier element being cohesively and electrically conductively connected to one resistance connection and the second free end region of the carrier element being connected to the second resistance connection in an electrically insulated manner, a spacer made of an electrically insulating material being arranged between the second free end region of the carrier element and the second resistance connection, those sides of the second free end region of the carrier element and of the second resistance connection which face one another abutting said spacer, and said spacer being able to be connected both to the second free end region of the carrier element and to the second resistance connection, and the spacer being able to be connected to the second free end region of the carrier element and/or to the second resistance connection by means of a releasable connection,
**characterized in that** the spacer (13) can be connected to the second free end region (10) of the carrier element (2) and/or to the second resistance connection (6) by means of a latching connection.

2. Battery sensor unit according to Claim 1, **characterized in that** the spacer (13) has one or more spring arms (19, 22) which extend from the carrier element (2) and the second resistance connection (6) transversely with respect to the longitudinal extent, one end of said spring arms being permanently arranged on the spacer (13), and said spring arms having, on their free other end, a latching hook (20, 23) which makes it possible to engage around an edge region of the carrier element (2) or the second resistance connection (6).

3. Battery sensor unit according to Claim 2, **characterized in that** a pair of aligned spring arms (19) having latching hooks (20) which face one another engages around the longitudinal sides of the carrier element (2) and/or the second resistance connection so as to hold said element and/or connection between said spring arms in the manner of tongs.

4. Battery sensor unit according to one of the preceding claims, **characterized in that** the free ends of a pair of aligned spring arms (22) project through a recess (24) in the carrier element (2) and/or in the resistance connection, and latching hooks (23) of said spring arms, which face away from one another, engage around the carrier element (2) and/or the resistance connection at the edge (25) of the recess (24).

5. Battery sensor unit according to Claims 3 and 4, **characterized in that** the spacer (13) is of approximately H-shaped design, the carrier element (2) and the second resistance connection (6) each being supported on a side of the crossbeam (14) of the "H", and the arms of the "H" which each extend to a side of the crossbeam (14) forming a pair of spring arms (19, 22), the latching hooks (20) of one pair of spring arms (19) being in the opposite direction to the latching hooks (23) of the other pair of spring arms (22).

6. Battery sensor unit according to Claim 5, **characterized in that** the spring arms (22) of one pair of spring arms (22) are at a shorter distance from one another than those of the other pair of spring arms (19).

7. Battery sensor unit according to either of Claims 5 and 6, **characterized in that** the crossbeam (14) of the "H" is in the form of a bending beam.

8. Battery sensor unit according to one of the preceding claims, **characterized in that** the spacer (13) is in one piece.

9. Battery sensor unit according to Claim 8, **characterized in that** the spacer (13) is a plastic injection-moulded part.

10. Battery sensor unit according to one of the preceding claims, **characterized in that** the first resistance connection (9) can be connected to a ground connection or to a load.

11. Battery sensor unit according to one of the preceding claims, **characterized in that** the carrier element (2) is cohesively connected to the first resistance connection (9) by means of brazing, in particular by means of resistance brazing, or by means of welding, in particular by means of resistance welding.

12. Battery sensor unit according to one of the preceding claims, **characterized in that** the resistance connections (9, 6) have connecting elements (11, 12) for conductive connection to an electronic evaluation unit.

## Revendications

1. Unité capteur de batterie comportant un dispositif de fixation, notamment une borne polaire, pouvant être raccordée sur un pôle d'une batterie de véhicule automobile, ledit dispositif de fixation étant relié électriquement à un élément support en forme de plaque, et un shunt de mesure planaire se développant, à une certaine distance, parallèlement à l'élément support, ledit shunt de mesure se composant d'une résistance et, immédiatement de chaque côté, de bornes de raccordement de la résistance, où l'élément support est raccordé, par l'une de ses extrémités libres, en assemblage par fusion de matière et en conduction électrique, à l'une des bornes de raccordement de la résistance et où la deuxième extrémité libre de l'élément support est raccordée, en isolation électrique, à la deuxième borne de raccordement de la résistance, où est disposé, entre la deuxième extrémité libre de l'élément support et la deuxième borne de raccordement de la résistance, un écarteur en matière électriquement isolante sur lequel s'appliquent, par leurs faces tournées l'une vers l'autre, la deuxième extrémité libre de l'élément support et la deuxième borne de raccordement de la résistance et qui peut être lié non seulement à la deuxième extrémité libre de l'élément support, mais aussi à la deuxième borne de raccordement de la résistance et où l'écarteur peut, au moyen d'une liaison démontable, être lié à la deuxième extrémité libre de l'élément support et/ou à la deuxième borne de raccordement de la résistance, **caractérisée par le fait que** l'écarteur (13) peut, au moyen d'une liaison encliquetable, être lié à la deuxième extrémité libre (10) de l'élément support (2) et/ou à la deuxième borne (6) de raccordement de la résistance.

2. Unité capteur de batterie selon la revendication 1, **caractérisée par le fait que** l'écarteur (13) comporte une ou plusieurs branches de ressort (19, 22) qui se développent perpendiculairement à la plus grande dimension de l'élément support (2) et de la deuxième borne de raccordement (6) de la résistance, lesdites branches de ressort étant, par l'une de leurs extrémités, fixées à l'écarteur (13) et comportant, à leur deuxième extrémité libre, un crochet encliquetable (20, 23), lesquels peuvent s'agripper dans une bordure de l'élément support (2) ou de la deuxième borne de raccordement (6) de la résistance.

3. Unité capteur de batterie selon la revendication 2, **caractérisée par le fait qu'**un couple de branches de ressort (19) ayant la même orientation enserrent, à la manière d'une pince en les entourant en leur milieu, avec leurs crochets encliquetables (20) tournés l'un vers l'autre, l'élément support (2) et/ou la deuxième borne de raccordement de la résistance.

4. Unité capteur de batterie selon l'une des revendications précédentes, **caractérisée par le fait qu'**un couple de branches de ressort (22) ayant la même orientation font saillie, par leurs extrémités libres, à travers un évidement (24) dans l'élément support (2) et/ou dans la borne de raccordement de la résistance et, par des crochets encliquetables (23), qui s'écartent l'un de l'autre, enserrent l'élément support (2) et/ou la borne de raccordement de la résistance au bord (25) de l'évidement (24).

5. Unité capteur de batterie selon les revendications 3 ou 4, **caractérisée par le fait que** l'écarteur (13) est réalisé à peu près en forme de H, l'élément support (2) et la deuxième borne (6) de raccordement de la résistance s'appliquant chacun sur un côté de la barre transversale (14) du "H" et les branches du "H", qui se développent chacune vers un côté de la barre transversale (14), formant un couple (19, 22) de branches de ressort, les crochets encliquetables (20) de l'un des couples (19) de branches de ressort étant dirigés dans le sens opposé aux crochets encliquetables (23) de l'autre couple (22) de branches de ressort.

6. Unité capteur de batterie selon la revendication 5, **caractérisée par le fait que** les branches de ressort (22) de l'un des couples (22) de branches de ressort sont à une faible distance de l'autre couple (19) de branches de ressort.

7. Unité capteur de batterie selon l'une des revendications 5 et 6, **caractérisée par le fait que** la barre transversale (14) du "H" est réalisée sous forme de barre cintrée.

8. Unité capteur de batterie selon l'une des revendications précédentes, **caractérisée par le fait que** l'écarteur (13) est réalisé en une seule pièce.

9. Unité capteur de batterie selon la revendication 8, **caractérisée par le fait que** l'écarteur (13) est une pièce en matière plastique moulée par injection.

10. Unité capteur de batterie selon l'une des revendications précédentes, **caractérisée par le fait que** la première borne (9) de raccordement de la résistance peut être reliée à une borne de masse ou à un consommateur.

11. Unité capteur de batterie selon l'une des revendications précédentes, **caractérisée par le fait que** l'élément support (2) est relié par assemblage à fusion de matière à la première borne (9) de raccordement de la résistance au moyen d'un brasage fort, notamment au moyen d'un brasage fort à résistance ou au moyen d'une soudure, notamment au moyen d'une soudure à résistance.

12. Unité capteur de batterie selon l'une des revendications précédentes, **caractérisée par le fait que** les bornes de raccordement (9, 6) de la résistance ont des éléments de raccordement (11, 12) vers une liaison conductive avec une unité électronique de traitement.
